Europäisches Patentamt

European Patent Office

Office européen des brevets

(11) Numéro de publication: **0 036 340**
**B1**

(12) **FASCICULE DE BREVET EUROPEEN**

(45) Date de publication du fascicule du brevet: **27.12.84**

(21) Numéro de dépôt: **81400193.9**

(22) Date de dépôt: **06.02.81**

(51) Int. Cl.³: **H 01 J 29/39**, G 01 T 1/29, H 01 L 31/02

(54) **Dispositif localisateur d'impact de particules ou de rayonnement lumineux et oscilloscope cathodique comportant un tel dispositif.**

(30) Priorité: **14.03.80 FR 8005736**

(43) Date de publication de la demande:
**23.09.81 Bulletin 81/38**

(45) Mention de la délivrance du brevet:
**27.12.84 Bulletin 84/52**

(84) Etats contractants désignés:
**DE GB**

(56) Documents cités:
**FR-A-2 251 907**
**FR-A-2 306 445**
**US-A-3 209 201**
**US-A-3 400 273**

**XEROX DISCLOSURE JOURNAL, vol. 4, no. 3, mai-juin 1979, Stanford, Conn. US JEROMIN: "X-ray detector array" pages 319-322 REVIEW OF SCIENTIFIC INSTRUMENTS, vol. 48, no. 6, juin 1977 New York, USA KOPPEL: "Direct soft X-ray response of a charge-coupled image sensor", pages 669-672**

(73) Titulaire: **THOMSON-CSF**
**173, Boulevard Haussmann**
**F-75379 Paris Cedex 08 (FR)**

(72) Inventeur: **Guyot, Lucien**
**THOMSON-CSF SCPI 173, bld Haussmann**
**F-75360 Paris Cedex 08 (FR)**

(74) Mandataire: **Mayeux, Michèle et al**
**THOMSON-CSF SCPI 173, Bld Haussmann**
**F-75379 Paris Cedex 08 (FR)**

Courier Press, Leamington Spa, England.

## Description

La présente invention concerne un dispositif localisateur d'impact de particules ou de rayonnement lumineux. Elle concerne également les oscilloscopes cathodiques comportant un tel dispositif.

On connaît dans l'art antérieur des localisateurs des coordonées x et y d'un point émissif P basés sur le principe suivant.

On dispose d'un plaque rectangulaire en un matériau de résistivité uniforme, dont deux côtés opposés sont bordés d'une électrode en un matériau faiblement résistif. On injecte un courant en un point P quelconque de cette plaque par une source de tension continue reliée entre la plaque et les électrodes. On sait qu'il circule dans chaque électrode des courants $i_1$ et $i_2$ tels que la coordonnée x du point P, sur un axe Ox per pendiculaire aux électrodes s'écrit:

$$x=(i_1-i_2)/(i_1+i_2).$$

Pour connaître la coordonnée y du point P sur un axe Oy perpendiculaire à Ox, il suffit de disposer sur la plaque deux autres électrodes perpendiculaires aux premières et d'injecter un courant au point P en utilisant ces électrodes. La coordonnée y du point P s'écrit en fonction des courants $i'_1$ et $i'_2$ qui circulent dans ces électrodes:

$$y=(i'_1-i'_2)/(i'_1+i'_2).$$

Par la demande de brevet FR—A—2.251.907, on connait un capteur de position à semi-conducteur permettant de déterminer les coordonnées suivant deux axes orthogonaux x et y d'un rayonnement incident. Ce capteur, qui est représenté sur la figure 2 de ce brevet, est constitué d'un substrat semi-conducteur 20 d'un premier type de conductibilité qui est recouvert sur l'une de ses faces d'une couche 20a de semi-conducteur d'un type de conductibilité opposé à celui du substrat 20 et sur la face opposée d'une couche 20b de semi-conducteur du même type de conductibilité que le substrat 20.

Chacune de ces faces comporte deux électrodes parallèles 21, 22 et 23, 25 et les électrodes d'une face sont perpendiculaires aux électrodes de l'autre face. Ces électrodes sont réalisées en un matériau faiblement résistif.

Ces électrodes reçoivent une polarisation particulière pour que le capteur de position soit polarisé en inverse.

Dans les pages 8 et 9, on trouve l'expression des coordonnées x et y en fonction de la charge qui apparaît sur les amplificateurs reliés aux diverses électrodes du capteur.

Par la demande de brevet FR—A—2.306.445, on connaît une cible pour dispositif de prise de vues constitué par un substrat semi-conducteur 2 recouvert d'une couche isolante 4 portant des électrodes de transfert et de stockage 6, 8, 10. Ce dispositif reçoit un rayonnement incident 2, 14, 16 qui crée des charges dans le semi-conducteur. Le distribution de charges sous chaque électrode peut être transférée sous l'électrode voisine et, de proche en proche, vers un arrangement de détecteurs ou elle est detectée.

Selon la revendication 1, la présente invention concerne un dispositif localisateur d'impact de particules, ou de rayonnement lumineux permettant de déterminer les coordonnées selon deux axes orthogonaux Ox et Oy de l'impact de particules ou de rayonnement lumineux, comportant un substrat semi-conducteur de surface rectangulaire, dont les côtés sont parallèles aux axes Ox et Oy:

— la détermination de la coordonnée selon l'axe Ox se fait par un système comportant plusieurs registres à décalages à transfert de charges, isolés les uns des autres et disposés l'un à côté de l'autre selon l'axe Oy, ces registres étant intégrés dans le substrat semi-conducteur, recouvert d'une couche isolante qui porte des électrodes de transfert et de stockage s'étendant selon l'axe Oy et communes à tous les registres, le substrat comportant une zone diffusée de type opposé à celui du substrat, à l'une des extrémités de la surface et parallèle aux électrodes et sous laquelle on peut transférer les charges en provenance de tous les registres;

—. la détermination de la coordonnée selon l'axe Oy se fait par les courant de lecture pouvant être délivrés par deux amplificateurs reliés aux extrémités selon l'axe Oy de la zone diffusée.

Le localisateur d'impact de particules selon la présente invention présente de nombreux avantages parmi lesquels on peut citer le fait qu'il permette la localisation d'une courbe en utilisant un balayage plus rapide, car plus simple, que le balayage télévision. En effet, la surface sensible du localisateur est divisée selon l'axe Ox en surface élémentaires qui sont déterminées par les dimensions des électrodes de stockage. L'existence même de ces surfaces élémentaires qui sont lues l'une après l'autre permet la localisation selon l'axe Ox alors que la mesure des courants de lecture pris aux extrêmités selon l'axe Ox de chaque surface élémentaire permet la localisation selon l'axe Oy du point d'impact des particules sur une surface élémentaire donnée.

Le dispositif selon l'invention associé à une mémoire qui stocke les valeurs successives des courants de lecture $i_1$ et $i_2$ peut être utilisé pour l'enregistrement de signaux électriques; notamment lorsqu'on ne dispose pour étudier ces signaux que d'un oscilloscope standard non doué de mémoire ou possédant une mémoire peu rapide. En effet, les signaux mémorisés peuvent être restitués à une cadence réglable.

D'autres objets, caractéristiques et résultats de l'invention ressortiront de la description suivante, donnée à titre d'exemple non limitatif et illustrée par les figures annexées qui représentent:

— La figure 1, un schéma illustrant le principe des localisateurs selon l'art connu;
— La figure 2, un localisateur à transfert de charges selon l'invention;
— La figure 3, un mode de réalisation particulier du dispositif selon l'invention.

Sur les différentes figures, les mêmes repères désignent les mêmes éléments, mais, pour des raisons de clarté, les cotes et proportions des différents éléments ne sont pas respectées.

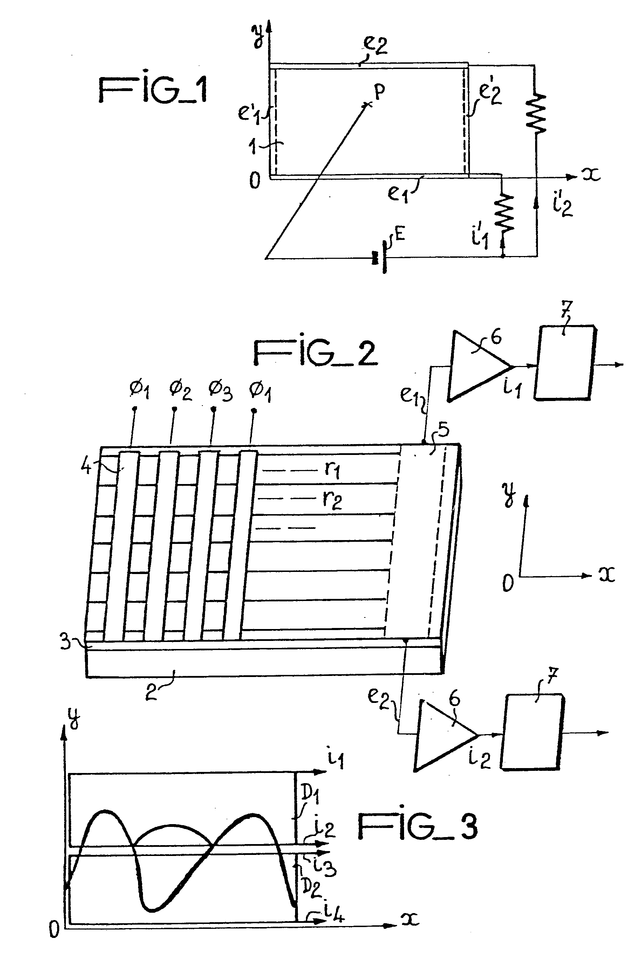

La figure 1, représente un schéma illustrant le principe des localisateurs selon l'art connu.

Ces localisateurs permettent de connaîre les coordonnées x et y d'un point émissif P dans un système d'axes rectangulaires Ox et Oy.

Le principe qui a déjà été précédemment décrit est le suivant.

On dispose d'une plaque rectangulaire 1 en un matériau de résistivité uniforme. Deux électrodes $e_1$ et $e_2$ bordent deux côtés opposés parallèles à l'axe Ox de cette plaque. Une source de tension continue E permet d'injecter un courant en un point P quelconque de la plaque. Cette, source est reliée entre la plaque et les électrodes. Si on appelle $i'_1$ et $i'_2$ les courants qui circulent dans les électrodes $e_1$ et $e_2$, la coordonnée y du point P s'écrit:

$$y=(i'_1-i'_2)/(i'_1+i'_2).$$

Pour obtenir la coordonnée x du point P, il faut de même injecter un courant au point P en utilisant deux électrodes $e'_1$ et $e'_2$ couvrant les deux autres bords de la plaque 1.

La figure 2, représente un localisateur à transfert de charges selon l'invention.

Ce localisateur comporte une surface principale constituée par plusieurs registres à décalages à transfert de charges $r_1$, $r_2$, $r_3$ ... disposés les uns au-dessus des autres selon l'axe Oy.

Ces registres sont intégrés sur le même substrat semi-conducteur 2 recouvert d'une couche isolante 3. Le substrat semi-conducteur le plus couramment employé est le silicium.

Des diffusions d'isolement consistant en un surdopage de substrat qui élève le seuil d'inversion et s'oppose ainsi à tout stockage des charges permettant de réaliser de façon connu plusieurs registres isolés les uns des autres sur le même substrat.

Sur la couche isolante 3, des électrodes 4 sont disposées parallèlement les unes aux autres et à l'axe Oy. Ces électrodes sont communes à tous les registres.

Les substrat semi-conducteur est soumis à l'impact de particules qui peuvent provenir d'un rayonnement lumineux, de l'image de l'écran d'un oscilloscope cathodique projetée sur le substrat par un système optique par exemple. Ce rayonnement lumineux peut arriver sur le localisateur soit du côté où se trouvent les électrodes 4 qui doivent alors être photosensibles, soit par l'autre côté. Les particules que reçoit le localisateur peuvent être aussi des électrons, les électrons du faisceau d'un oscilloscope par exemple.

Les électrodes 4 déterminent sur le substrat 2 des surfaces élémentaires. Les charges dues à l'impact des particules qui sont stockées sous les électrodes sont lues par transfert simultané des charges dans tous les registres, d'une électrode 4 à la suivante, selon la direction Ox, jusque dans une zone diffusée 5 commune à tous les registres.

Pour provoquer le transfert des charges d'une électrode à la suivante, les électrodes 4 peuvent être soumises à trois signaux d'horloge périodiques de même période T, mais déphasés l'un par rapport à l'autre, $\emptyset_1$, $\emptyset_2$, $\emptyset_3$.

Le transfert des charges dans une direction donnée peut être également obtenu, de façon cunnue, en utilisant des hétérogénités de structure telles qu'une surépaisseur d'oxyde ou des concentrations d'impuretés dans le substrat.

La zone diffusée 5 est de type opposé à celui du substrat. Sa dimension selon l'axe Oy est au moins égale à la dimension qu'occupe selon l'axe Oy l'ensemble des registres. Les charges en provenance de tous les registres sont donc transférées sous cette zone diffusée 5.

Les courbes que permet de localiser le dispositif représenté sur la figure 2 ne doivent posséder qu'une seule valeur de y pour chaque valeur de x.

Le fonctionnement du localisateur selon l'invention se fait en deux temps:

— dans un premier temps, le localisateur est soumis à l'impact des particules;
— dans un second temps, le localisateur est soustrait à l'impact des particules et on provoque le transfert de charges sous la zone 5. A un instant donné, on sait (en tenant compte du nombre de coups d'horloge ayant permis le transfert des charges sous la zone 5), quelle électrode 4 c'est-à-dire quelle surface élémentaire a reçu l'impact qui a créé les charges se trouvant sous la zone 5. La localisation selon Ox est donc réalisée. Pour réaliser la localisation selon Oy, on utilise le principe des localisateurs selon l'art connu. Les extrêmités selon Ox de la zone 5 sont reliées à deux électrodes $e_1$ et $e_2$ connectées à deux amplificateurs 6. Les amplificateurs 6 délivrent des courants $i_1$ et $i_2$ lors de l'arrivée de chaque paquet de charges sous la zone diffusée 5.

La différence normée des courants

$$(i_1 - i_2)/(i_1 + i_2)$$

donne la coordonnée y. De plus, la somme des courants donne l'intensité du rayonnement lumineux ou du faisceau d'électrons reçu.

Les courants $i_1$ et $i_2$ sont mis en mémoire séparément, en analogique ou après numérisation, comme dans le cas de la figure 2 où les mémoire sont repérées par 7. Les courants $i_1$ et $i_2$ peuvent aussi être traités en temps réel d'analyse de façon à obtenir le rapport

$$(i_1 - i_2)/(i_1 + i_2)$$

qui est ensuite mémorisé.

La vitesse de la localisation de l'impact des particules qui est réalisée grâce au dispositif de la figure 2 peut être adaptée à la vitesse des circuits de traitement des courants $i_1$ et $i_2$.

La vitesse de localisation peut être très élevée. La fréquence des signaux $\emptyset_1$, $\emptyset_2$, $\emptyset_3$ de transfert peut aller de 10 à 100 MHz.

La vitesse de localisation peut être aussi très faible puisqu'il est possible d'obtenir une mémorisation des données dans le silicium de plusieurs minutes si le silicium est refroidi à basse température.

Le dispositif localisateur représenté sur la figure 2 peut être utilisé, comme nous l'avons vu, pour mémoriser les coordonnées de la courbe y=f(x) qui apparaît sur l'écran d'un oscilloscope. Pour visualiser à nouveau cette courbe, il suffit d'appliquer aux plaques d'un oscilloscope cathodique les coordonnées mises en mémoire.

Lorsqu'on désire localiser un oscillogramme constitué par une courbe présentant plusieurs valeurs de y pour la même valeur de x, comme c'est le cas sur la figure 3, il suffit d'utiliser plusieurs dispositifs $D_1$, $D_2$, tels que ceux que nous venons de décrire, disposés l'un au dessus de l'autre selon Oy. Ces dispositifs délivrent des courants $i'_1$ et $i'_2$, $i_3$ et $i_4$ qui permettent la localisation de plusieurs points d'impact selon Oy pour une même valeur de x. Le balayage des surfaces sensibles selon des surfaces élémentaires, par des signaux d'horloge $\emptyset_1$, $\emptyset_2$, $\emptyset_3$ appliqués à des électrodes de transfert de charges peut avantageusement être commun aux différents dispositifs $D_1$, $D_2 \ldots$

**Revendications**

1. Dispositif localisateur d'impact de particules ou de rayonnement lumineux permettant de déterminer les coordonnées selon deux axes orthogonaux Ox et Oy de l'impact de particules ou de rayonnement lumineux, comportant un substrat semi-conducteur (2) de surface rectangulaire, dont les côtés sont parallèles aux axes Ox et Oy, et caractérisé en ce que:

— la détermination de la coordonnée selon l'axe Ox se fait par un système comportant plusieurs registres à décalages à transfert de charges ($r_1$, $r_2 \ldots$), isolés les uns des autres et disposés l'un à côté de l'autre selon l'axe Oy, ces registres étant intégrés dans le substrat semi-conducteur (2), recouvert d'une couche isolante (3) qui porte des électrodes (4) de transfert et de stockage s'étendant selon l'axe Oy et communes à tous les registres, le substrat (2) comportant une zone diffusée (5) de type opposé à celui du substrat, à l'une des extrémités de la surface et parallèle aux électrodes et sous laquelle on peut transférer les charges en provenance de tous les registres;

— la détermination de la coordonnée selon l'axe Oy se fait par les courants de lecture ($i_1$ et $i_2$) pouvant être délivrés par deux amplificateurs (6) reliés aux extrémités selon l'axe Oy de la zone diffusée (5).

2. Dispositif selon la revendication 1, caractérisé en ce que le substrat semi-conducteur (2) est en silicium.

3. Dispositif selon l'une des revendications 1 ou 2, caractérisé en ce que les électrodes (4) sont photosensibles.

4. Dispositif selon l'une des revendications 1 à 3, caractérisé en ce qu'il comporte des mémoires (7) qui stockent les valeurs successives de courants de lecture ($i'_1$ et $i'_2$) ou de leur combinaison homographique

$$(i'_1 - i'_2)/(i'_1 + i'_2).$$

5. Application d'un dispositif selon l'une des revendications 1, 2 ou 3 à un oscilloscope cathodique, le substrat semi-conducteur du dispositif recevant l'image de l'écran de l'oscilloscope projetée par un système optique ou le substrat semi-conducteur (2) du dispositif recevant les électrons du faisceau de l'oscilloscope.

6. Dispositif localisateur, caractérisé en ce qu'il est constitué par plusieurs dispositifs ($D_1$, $D_2 \ldots$) selon l'une des revendications 1 à 4, disposés l'un au dessus de l'autre selon l'axe Oy.

7. Dispositif selon la revendication 6, caractérisé en ce que ces dispositifs ($D_1$, $D_2 \ldots$) reçoivent les mêmes signaux d'horloge ($\emptyset_1$, $\emptyset_2$, $\emptyset_3$) appliqués aux électrodes de transfert des charges.

**Patentansprüche**

1. Vorrichtung zum Lokalisieren des Aufpralls von Partikeln oder von Lichtstrahlung, mit der es möglich ist, die Koordinaten des Aufpralls von Partikeln oder von Lichtstrahlung in einem rechtwinkligen Koordinatennetz Ox/Oy zu bestimmen, mit einem Halbleitersubstrat (2), das eine rechteckige Oberfläche besitzt und dessen Seiten zu den Achsen Ox und Oy parallel verlaufen, dadurch gekennzeichnet, daß die Bestimmung des Koordinatenwerts in x-Richtung durch ein System mit mehreren Schieberegistern ($r_1$, $r_2$,...) vom Ladungstransfertyp erfolgt, die gegeneinander isoliert nebeneinander in y-Richtung aufgereiht in dem Halbleitersubstrat (2) integriert sind, wobei dieses Substrat (2) mit einer Isolierschicht (3) bedeckt ist, die sich in y-Richtung erstreckende und allen Registern gemeinsame Transfer- und Speicherelektroden (4) trägt, und wobei das Substrat an einem der Enden der Oberfläche und parallel zu den Elektroden eine diffundierte Zone (5) entgegengesetzten Leitfähigkeitstyps wie das Substrat besitzt, unter die man die von allen Registern kommenden Ladungen transferieren kann, und daß die Bestimmung des Koordinatenwerts in y-Richtung durch Auswertung der Leseströme ($i_1$ und $i_2$) erfolgt, die von zwei an die Enden der diffundierten Zone in y-Richtung angeschlossenen Verstärkern (6) geliefert werden können.

2. Vorrichtung nach Anspruch 1, dadurch gekennzeichnet, daß das Halbleitersubstrat (2) aus Silizium ist.

3. Vorrichtung nach einem der Ansprüche 1 oder 2, dadurch gekennzeichnet, daß die Elektroden (4) lichtempfindliche Elektroden sind.

4. Vorrichtung nach einem der Ansprüche 1 bis 3, dadurch gekennzeichnet, daß sie Speicher (7) enthält, die die aufeinanderfolgenden Leseströme ($i'_1$ und $i'_2$) oder deren homographische Kombination

$$(i'_1 - i'_2)/(i'_1 + i'_2)$$

speichern.

5. Anwendung einer Vorrichtung nach einem der Ansprüche 1, 2 oder 3 auf eine Kathodenstrahlröhre, wobei das Halbleitersubstrat der Vorrichtung entweder das Bild des Leuchtschirms der Röhre, das von einem optischen System projiziert wird, oder die Elektronen des Kathodenstrahls der Röhre empfängt.

6. Vorrichtung zum Lokalisieren, dadurch gekennzeichnet, daß sie aus mehreren Vorrichtungen ($D_1$, $D_2$,...) nach einem der Ansprüche 1 bis 4 besteht, die in y-Richtung übereinanderliegen.

7. Vorrichtung nach Anspruch 6, dadurch gekennzeichnet, daß diese Vorrichtungen ($D_1$, $D_2$,...) dieselben Taktsignale ($\emptyset_1$, $\emptyset_2$, $\emptyset_3$) erhalten, die auch an die Ladungstransferelektroden angelegt werden.

**Claims**

1. A device for localizing the impact of particles or luminous radiation, allowing to determine the co-ordinate values according to two orthogonal axes Ox and Oy of the impact of particles or of luminous radiation, comprising a semi-conducting substrate (2) having a rectangular surface, the sides of which are disposed parallelly to the axes Ox and Oy, the device being characterized in that

— the co-ordinate value according to the Ox axis is determined by a system comprising a plurality of shift registers of the charge transfer type ($r_1$, $r_2$,...), which are mutually insulated and disposed side by side along the Oy axis, these registers being integrated on the semiconducting substrate (2) and being covered by an insulating layer (3) which bears transfer and memory electrodes (4), these electrodes extending along the Oy axis and being common to all the registers, the substrate (2) comprising a diffused zone (5) of opposite type to that of the substrate, which zone is located at one end of the surface and parallelly to the electrodes, and under which the charges coming from all the registers can be transferred;

— and that the co-ordinate value along the Oy axis is determined by the read currents ($i_1$ and $i_2$) which can be furnished by two amplifiers (6) connected to the end of the diffused zone (5) along the Oy direction.

2. A device according to claim 1, characterized in that the semiconductor substrate (2) is made of silicium.

3. A device according to one of claims 1 or 2, characterized in that the electrodes (4) are photosensitive electrodes.

4. A device according to one of the claims 1 to 3, characterized in that it comprises memories (7) which store the successive values of the read currents ($i'_1$ and $i'_2$) or of their homographic combination

$$(i'_1 - i'_2)/(i'_1 + i'_2).$$

5. The application of a device according to one of claims 1, 2 or 3 to a cathode ray tube, the semiconducting substrate of the device receiving either the image of the cathode ray tube screen projected by an optical system, or the electrons of the cathode ray.

6. A device for localizing the impact of particles, characterized in that it comprises a plurality of devices ($D_1$, $D_2$,...) according to one of the claims 1 to 4, which are superposed in Oy direction.

7. A device according to claim 6, characterized in that the devices ($D_1$, $D_2$,...) receive the same clock signals ($\emptyset_1$, $\emptyset_2$, $\emptyset_3$) which are applied to the charge transfer electrodes.

0 036 340

FIG_1

FIG_2

FIG_3